## Europäisches Patentamt

## European Patent Office

## Office européen des brevets

(11) Numéro de publication: **0 247 680**
**B1**

(12) # FASCICULE DE BREVET EUROPEEN

(45) Date de publication du fascicule du brevet:
**25.07.90**

(51) Int. Cl.⁵: **C30B 25/14,** C30B 25/16

(21) Numéro de dépôt: **87200929.5**

(22) Date de dépôt: **19.05.87**

(54) Procédé de réalisation d'un dispositif semiconducteur, incluant le dépôt en phase vapeur de couches sur un substrat.

(30) Priorité: **27.05.86 FR 8607538**

(43) Date de publication de la demande:
**02.12.87 Bulletin 87/49**

(45) Mention de la délivrance du brevet:
**25.07.90 Bulletin 90/30**

(84) Etats contractants désignés:
**DE FR GB NL**

(56) Documents cités:
**US-A- 3 930 908**
**US-A- 4 316 430**
**US-A- 4 533 410**

(73) Titulaire: **LABORATOIRES D'ELECTRONIQUE PHILIPS,
3, Avenue Descartes, F-94450 Limeil-Brévannes(FR)**
(84) Etats contractants désignés: **FR**

(73) Titulaire: **N.V. Philips' Gloeilampenfabrieken,
Groenewoudseweg 1, NL-5621 BA Eindhoven(NL)**
(84) Etats contractants désignés: **DE GB NL**

(72) Inventeur: **Frijlink, Peter Michael Société Civile S.P.I.D.,
209, rue de l'Université, F-75007 Paris(FR)**

(74) Mandataire: **Landousy, Christian et al, Société Civile
S.P.I.D. 156, Boulevard Haussmann, F-75008 Paris(FR)**

ACTORUM AG

## Description

L'invention concerne un procédé de réalisation d'un dispositif semiconducteur, incluant le dépôt en phase vapeur de couches sur un substrat, dans la chambre d'un réacteur, à l'aide de gaz vecteurs et de gaz réactants.

Par gaz réactant, l'on entend tout gaz nécessaire à la réalisation d'une opération ou réaction.

Par réacteur, l'on entend tout lieu, ou toute enceinte où se fait l'opération ou la réaction.

Par gaz vecteur, il convient d'entendre tout gaz compatible avec la réaction ou l'opération, mais ne prenant pas nécessairement part à cette opération ou réaction. Ce peut être par exemple un gaz complètement neutre vis-à-vis de la réaction, ou bien constituant l'atmosphère ou le milieu favorable à la bonne mise en oeuvre de la réaction.

L'invention trouve son application dans la réalisation de dispositifs actifs semiconducteurs incluant des couches épitaxiales ou des couches implantées, par exemple en matériaux du groupe III-V.

Il est connu du brevet US-3 930 908 d'introduire dans la chambre d'un réacteur d'épitaxie en phase vapeur, au moyen de vannes de structures classiques, des composés gazeux réactants mêlés à un gaz vecteur. La régulation, l'interruption ou la commutation de l'écoulement de ces gaz sont alors faites suivant les cas, par l'ouverture ou la fermeture de robinets ou de vannes, mettant en oeuvre le déplacement de pièces mécaniques les unes par rapport aux autres.

Cependant, l'utilisation de ces robinets ou de ces vannes classiques se révèle difficile, voire même impossible dans de nombreux cas et en particulier :
- lorsque les gaz utilisés sont corrosifs,
- lorsque ces gaz sont polluants et qu'une décontamination est nécessaire pour réaliser la commutation ultérieure avec un autre gaz : cette décontamination est rendue difficile du fait que les matériaux qui constituent les vannes sont le plus souvent attaqués par les produits utilisés pour la décontamination,
- lorsque ces gaz doivent être maintenus à haute température durant leur écoulement, ce qui peut être le cas de composés gazeux qui cristallisant à température ambiante, ou se solidifient : en effet, aux températures élevées d'épitaxie en phase vapeur, telles que les températures comprises entre 600 et 900°C, les matériaux qui répondent aux conditions de pureté imposées par l'épitaxie en phase vapeur, ne sont pas des matériaux qui permettent de réaliser de façon simple des vannes qui répondent aux conditions d'étanchéité. Ainsi en épitaxie en phase vapeur, les métaux sont exclus pour la raison qu'il peuvent contaminer, ou être attaqués par le gaz réactant,
- lorsque ces gaz doivent être utilisés sous de très faible débit ou en très faible quantité : en effet les variations de pression parasites dues à la commutation peuvent engendrer des erreurs sur l'épaisseur des couches épitaxiales ou des erreurs sur le dopage des couches réalisées. Ce qui entraîne que des épaisseurs de couches très minces, des changements de composition abrupts ou des changements de dopage abrupts ne peuvent pas être obtenus au moyens des vannes de structures classique.
- lorsque ces gas présentent la propriété d'être adsorbés ou désorbés par les matériaux constituant les tubes qui les transportent. Ainsi le phénomène d'adsorption et désorption des parois des tubes après le point de commutation donne souvent lieu à des effets de mémoire inacceptables si ces tubes sont longs ou froids, tout particulièrement si ces gaz à commuter ont des molécules à fort moment bipolaire. Ces effets mémoires peuvent provoquer aussi des erreurs sur l'épaisseur des couches ou le dopage.

Pour toutes ces raisons, les vannes classiques doivent être évitées.

C'est pourquoi la présente invention propose un procédé de réalisation qui est dénué de ces inconvénients.

Selon la présente invention ce but est atteint à l'aide d'un procédé tel que défini dans le préambule, caractérisé en ce qu'un gaz vecteur et un gaz réactant sont introduits dans la chambre du réacteur au moyen d'un système de trois tubes coaxiaux, dont le premier ou tube interne est de diamètre inférieur au second ou tube intermédiaire, qui est lui-même de diamètre inférieur au troisième tube ou tube externe, tubes dont les premières extrémités sont indépendantes, mais dont les secondes extrémités situées à proximité les unes des autres coopèrent pour former la vanne qui contrôle l'introduction du gaz réactant dans la zone chaude de la chambre du réacteur mêlé à un gaz vecteur, ces tubes étant disposés de telle manière que :
- ladite seconde extrémité du tube interne débouche dans le tube intermédiaire,
- ladite seconde extrémité du tube intermédiaire munie d'une restriction, débouche dans le tube externe,
- ladite seconde extrémité du tube externe, munie d'une restriction, débouche dans la chambre du réacteur à proximité de la zone chaude,
- ladite première extrémité du tube intermédiaire est munie d'une vanne V,
en ce que le gaz réactant est introduit par la première extrémité du tube interne et circule en direction de la seconde extrémité vers le tube intermédiaire,
en ce que le fluide vecteur est introduit par la première extrémité du tube externe et circule en direction de la seconde extrémité vers la chambre du réacteur, en ce que, le débit du gaz vecteur étant prévu très supérieur au débit du gaz réactant, le système de tubes se conduit comme une vanne de commutation qui dirige la totalité du gaz réactant vers la chambre du réacteur lorsque la vanne V est fermée, et en ce que le système de tubes se conduit comme une vanne de commutation qui dirige la totalité du gaz réactant vers la première extrémité du tube intermédiaire lorsque la vanne V est ouverte.

Selon l'invention ce procédé peut être en outre caractérisé en ce que un ou plusieurs autres gaz réactants sont introduits dans la chambre du réacteur par un ou plusieurs autres de tels systèmes de trois tubes.

Le procédé selon l'invention présente, entre autres, les avantages suivants :
- le système de tubes, qui constitue à lui seul la vanne d'introduction des gaz réactants dans la chambre, pouvant être réalisé en un matériau tel que le quartz qui répomd aux conditions de pureté, des couches épitaziales d'une très grande qualité peuvent être obtenues ; de plus, lorsque le système de tubes est réalisé en un tel matériau, la décontamination éventuelle est facilement obtenue à l'aide d'un gaz chloré par exemple, ce qui rend la mise en oeuvre du procédé de réalisation des couches épitaziales plus simple, et garantit le maintien de la qualité des couches au cours du temps ;

- le système de tubes permettant une commutation rapide dénuée d'espaces morts où le gaz reste stagnant et où sont engendrées des traînées de composé gazeux après commutation, par exemple dues à la désorption des parois, des épaisseurs de couches très minces, des changements de composition abrupts ou des changements de dopage abrupts peuvent être obtenus ;

D'une façon générale, à l'aide du procédé selon l'invention les couches épitaxiales ou implantées sont obtenues de façon plus simple et sont de meilleure qualité.

L'invention sera mieux comprise à l'aide de la description suivante illustrée par les figures annexées dont :

- la figure 1 qui représente schématiquement un réacteur pour l'élaboration de couches par épitaxie en phase gazeuse, ce réacteur étant muni d'un dispositif selon l'invention ;

- la figure 2 qui représente schématiquement le dispositif selon l'invention ;

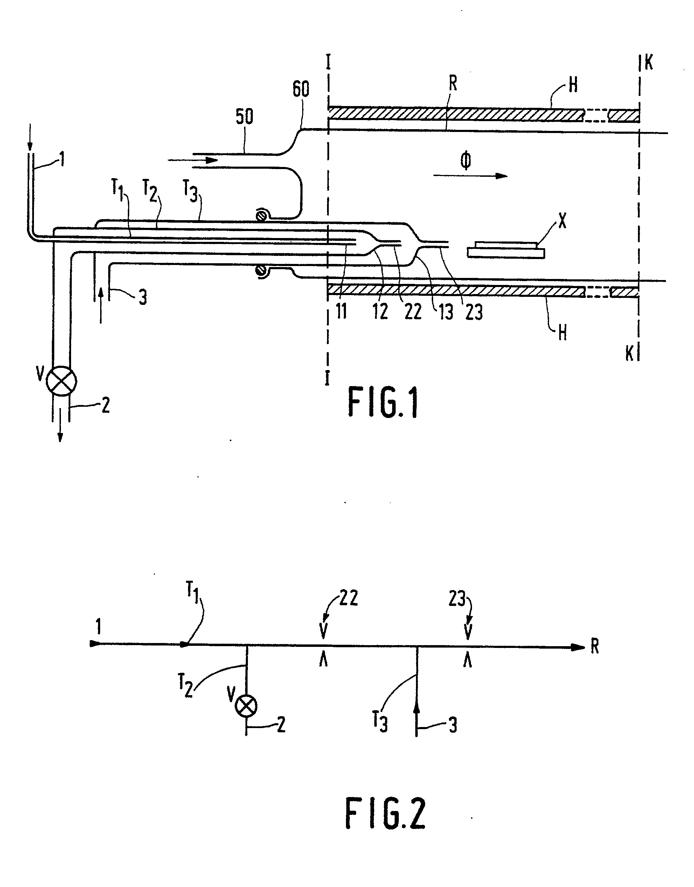

Tel que représenté sur la figure 1, le dispositif mis en oeuvre dans le procédé de réalisation d'un dispositif semiconducteur selon l'invention comprend un système de trois tubes $T_1$, $T_2$, $T_3$ coaxiaux.

Le premier tube $T_1$ dit tube interne est de diamètre inférieur au second tube $T_2$ dit tube intermédiaire. Ce second tube $T_2$ est lui-même de diamètre inférieur au troisième tube $T_3$ dit tube externe.

Les extrémités 1, 2 et 3 dites premières extrémités des trois tubes $T_1$, $T_2$, $T_3$ sont indépendantes. Les trois tubes $T_1$, $T_2$, $T_3$ ne deviennent solidaires et coaxiaux qu'au voisinage de leurs secondes extrémités 11, 12, 13.

La seconde extrémité 11 du tube interne $T_1$ débouche dans le tube intermédiaire $T_2$, à proximité de la seconde extrémité 12 de ce dernier.

La seconde extrémité 12 du tube intermédiaire $T_2$ est munie d'une restriction 22, et débouche dans le tube externe $T_3$, à proximité de la seconde extrémité 13 de ce dernier.

La seconde extrémité 13 du tube externe $T_3$ est munie d'une restriction 23, et débouche dans la chambre du réacteur R.

La première extrémité 2 du tube intermédiaire $T_2$ est munie d'une vanne V.

La chambre du réacteur R comprend une enceinte dans laquelle est placé, sur un porte-échantillon, un échantillon X semiconducteur monocristallin. Le porte-échantillon est placé à proximité d'une source de chaleur H externe à la chambre, en sorte que l'enchantillon se trouve dans une zone chaude dont la température est celle qui est requise pour la croissance épitaxiale en phase vapeur.

Les composés nécessaires à la croissance épitaxiale d'une couche, ou réactants, sont introduits sous forme gazeuse et forment un flux $\phi$ qui circule d'une extrémité 60 de la chambre en direction d'une sortie à l'autre extrémité de la chambre, et qui passe dans la zone chaude de la chambre en suivant le sens indiqué par la flèche sur la figure 1.

Les gaz réactants peuvent être soit des produits entrant dans la composition de la couche épitaxiale elle-même, soit des produits destinés au dopage de cette couche. Ces gaz réactants sont mêlés à un gaz qui est neutre pour le réacteur, dit gaz vecteur, et leur pression partielle par rapport à ce gaz neutre doit être déterminée avec une grande précision.

Comme il a été dit précédemment, certains de ces gaz réactants présentent l'inconvénient d'être fortement adsorbés par les parois froides. Ces gaz doivent alors obligatoirement être introduits dans la zone chaude du réacteur délimitée par les plans dont la trace est II' et KK' sur la figure 1.

Selon l'invention, le gaz réactant est introduit par l'extrémité 1 du tube interne $T_1$ et circule en direction de la seconde extrémité 11 vers le tube intermédiaire $T_2$.

Le gaz vecteur est introduit par l'extrémité 3 du tube externe $T_3$ et circule en direction de sa seconde extrémité 13 vers la chambre du réacteur R.

Comme il est montré sur la figure 2 qui représente le schéma équivalent au système, lorsque la vanne V est fermée, le système se comporte comme une vanne de commutation qui dirige la totalité du gaz réactant vers la chambre R.

Lorsqu'au contraire la vanne V est ouverte, le système se comporte comme une vanne de commutation qui dirige la totalité du gaz réactant vers la première extrémité 2 du tube intermédiaire $T_2$, le débit du gaz vecteur étant très supérieur au débit du gaz réactant, de l'ordre de 5 à 10 fois.

Le système conforme à l'invention procure donc les avantages cités précédemment, et tout particulièrement celui d'amener le gaz réactant à proximité immédiate de la zone chaude, comme il est montré figure 1, ce qui permet d'éviter les phénomènes d'adsorption et désorption après commutation et donc d'éviter l'inconvénient de l'effet mémoire.

D'autre part, il peut être prévu dans la chambre du réacteur R, à proximité du débouché 23 du tube $T_3$ une arrivée 50 pour des composés gazeux moins sensibles aux parois froides, circulant vers la sortie de la chambre R, dans le même sens que le gaz réactant et le premier gaz vecteur.

Ces composés peuvent prévenir d'un dispositif tel que celui qui est décrit dans EP-A 0 206 370 (la demande de brevet français déposée sous le numéro 85 07 204). Cette demande décrit un dispositif qui permet le contrôle très précis des pressions partielles de chacun des gaz réactants, conduisant à l'élaboration de couches épitaxiales en phase gazeuse dont la composition et l'épaisseur sont très précis.

Enfin il peut être prévu, dans la chambre du réacteur, à l'extrémité 60 de cette dernière, un ou plusieurs autres dispositifs selon la présente invention pour différents gaz réactants.

Un exemple de gaz réactant, qui est fortement adsorbé par les parois froides et cependant couramment utilisé dans la réalisation des dispositifs semiconducteurs pour le dopage des couches, spécialement d'arséniure de gallium (GaAs), est l'hydrure de sélénium ($H_2Se$). Il est clair que le système de tubes selon l'invention est particulièrement favorable à la réalisation de couches épitaxiales dopées au sélénium (Se).

Un matériau très favorable à la réalisation du système de tube selon l'invention est le quartz, car ce matériau est particulièrement aisé à décontaminer dans l'application à la réalisation de dispositif semiconducteurs par exemple du groupe III-V. De plus de quartz répond à toutes les conditions de pureté favorables à l'élaboration de couches épitaxiales de haute qualité.

On notera que le bon fonctionnement du système de tubes selon l'invention n'est pas dépendant de la bonne qualité de la vanne V (voir figure 1). En effet cette vanne peut par exemple fuir légèrement sans que le fonctionnement du système en soit perturbé. Ceci assure une grande durée de vie au système selon l'invention.

**Revendications**

1. Procédé de réalisation d'un dispositif semiconducteur, incluant le dépôt en phase vapeur de couches sur un substrat, dans la chambre d'un réacteur, à l'aide de gaz vecteurs et de gaz réactants, caractérisé en ce qu'un gaz vecteur et un gaz réactant sont introduits dans la chambre du réacteur au moyen d'un sytème de trois tubes coaxiaux, dont le premier ou tube interne est de diamètre inférieur au second ou tube intermédiaire, qui est lui-même de diamètre inférieur au troisième tube ou tube externe, tubes dont les premières extrémités sont indépendantes, mais dont les secondes extrémités situées à proximité les unes des autres coopèrent pour former la vanne qui contrôle l'introduction du gaz réactant dans la zone chaude de la chambre du réacteur mêlé à un gaz vecteur, ces tubes étant disposés de telle manière que :
- ladite seconde extrémité du tube interne débouche dans le tube intermédiaire,
- ladite seconde extrémité du tube intermédiaire munie d'une restriction, débouche dans le tube externe,
- ladite seconde extrémité du tube externe, munie d'une restriction, débouche dans la chambre du réacteur à proximité de la zone chaude,
- ladite première extrémité du tube intermédiaire est munie d'une vanne V,
en ce que le gaz réactant est introduit par la première extrémité du tube interne et circule en direction de la seconde extrémité vers le tube intermédiaire,
en ce que le fluide vecteur est introduit par la première extrémité du tube externe et circule en direction de la seconde extrémité vers la chambre du réacteur, en ce que, le débit du gaz vecteur étant prévu très supérieur au débit du gaz réactant, le système de tubes se conduit comme une vanne de commutation qui dirige la totalité du gaz réactant vers la chambre du réacteur lorsque la vanne V est fermée, et en ce que le système de tubes se conduit comme une vanne de commutation qui dirige la totalité du gaz réactant vers la première extrémité du tube intermédiaire lorsque la vanne V est ouverte.

2. Procédé selon la revendicaion 1, caractérisé en ce qu'un ou plusieurs autres gaz réactants et vecteurs sont introduits respectivement par un ou plusieurs autres systèmes de trois tubes coaxiaux dans la chambre du réacteur.

3. Procédé selon l'une des revendications 1 ou 2, caractérisé en ce que le(les) système(s) de trois tubes est (sont) fait(s) de quartz.

**Patentansprüche**

1. Verfahren zum Herstellen einer Halbleiteranordnung einschließlich der Abscheidung aus der Gasphase von Schichten auf ein Substrat in der Reaktionskammer mit Hilfe von Vektorgasen und Reaktionsgasen, dadurch gekennzeichnet, daß ein Vektorgas und ein Reaktionsgas mittels eines aus drei koaxialen Rohren bestehenden Systems in die Reaktionskammer eingeleitet werden, von denen das erste oder innere Rohr einen geringeren Durchmesser hat als das zweite oder Zwischenrohr, das an sich einen geringeren Durchmesser hat als das dritte oder Außenrohr, wobei von diesen Rohren die ersten Enden beliebig sind, von denen aber die zweiten Enden, die in der Nähe von einander liegen, miteinander zusammenarbeiten zum Bilden einer Schleuse, die das Einführen des Reaktionsgases in die heiße Zone der Reaktionskammer, das mit einem Vektorgas gemischt ist, regelt, wobei diese Rohre derart angeordnet sind, daß:
- das genannte zweite Ende des inneren Rohres in das Zwischenrohr mündet,
- das genannte zweite Ende des Zwischenrohres, das mit einer Einengung versehen ist, in das Außenrohr mündet,
- das genannte zweite des Außenrohres, das mit einer Einengung versehen ist, in der Nähe der heißen Zone in die Reaktionskammer mündet,
- das genannte erste Ende des Zwischenrohres mit einer Schleuse V versehen ist,
daß das Reaktionsgas durch das erste Ende des inneren Rohres eingeleitet wird und in einer Richtung des zweiten Endes zum Zwischenrohr hin umläuft, daß das Vektorgas durch das erste Ende eines Außenrohres eingeleitet wird und in Richtung des zweiten Endes zur Reaktionskammer hin umläuft, daß die vorgesehene Vektorgasmenge viel höher ist als die Reaktionsgasmenge, wobei das Rohrsystem als eine Regelschleuse wirkt, die die Gesamtmenge des Reaktionsgases zu der Reaktionskammer hin regelt wenn die Schleuse V geschlossen ist, und daß das Rohrsystem als Regelschleuse wirkt, die die Gesamtmenge des Reaktionsgases zu dem ersten Ende des Zwischenrohres hin regelt, wenn die Schleuse V geöffnet ist.

2. Verfahren nach Anspruch 1, dadurch gekennzeichnet, daß ein oder mehrere Reaktionsgase und Vektorgase durch ein oder mehrere andere Systeme von drei Koaxialrohren in die Reaktionskammer eingeleitet werden.

3. Verfahren nach einem der Ansprüche 1 oder 2, dadurch gekennzeichnet, daß das (die) System(e) von drei Rohren aus Quarz hergestellt ist (sind).

## Claims

1. A method of manufacturing a semiconductor device including the step of depositing from the vapour phase layers on a substrate in the chamber of a reactor by means of a vector gas and a reactant gas, characterized in that the vector gas and the reactant gas are introduced into the chamber of the reactor by means of a system of three coaxial tubes, the first of which (the inner tube) has a diameter smaller than that of the second tube (the intermediate tube), which in turn has a diameter smaller than that of the third tube (outer tube), the first ends of these tubes being independent, but the second ends thereof situated in the proximity of each other cooperating with each other so as to form a valve controlling the introduction of the reactant gas into the hot zone of the chamber of the reactor mixed with the vector gas, these tubes being disposed in such a manner that:
   - the said second end of the inner tube merges into the intermediate tube,
   - the said second end of the intermediate tube provided with a restriction merges into the outer tube,
   - the said second end of the outer tube provided with a restriction merges into the chamber of the reactor in the proximity of the hot zone,
   - the said first end of the intermediate tube is provided with a valve V,
   in that the reactant gas is introduced through the first end of the inner tube and circulates in the direction of the second end to the intermediate tube, in that the vector gas is introduced through the first end of the outer tube and circulates in the direction of the second end to the chamber of the reactor, in that, the flow rate of the vector gas being chosen to be much higher than the flow rate of the reactant gas, the tube system behaves like a commutation valve, which directs the whole quantity of reactant gas to the chamber of the reactor when the valve V is closed, and in that the tube system behaves like a commutation valve, which directs the whole quantity of reactant gas to the first end of the intermediate tube when the valve V is opened.

2. A method as claimed in Claim 1, characterized in that one or several other reactant gases and vector gases are introduced through one or several other respective systems of three coaxial tubes into the chamber of the reactor.

3. A method as claimed in any one of Claims 1 or 2, characterized in that the system(s) of three tubes is (are) made of quartz.

FIG.1

FIG.2